# EUROPEAN PATENT APPLICATION

(11) **EP 2 963 692 A1**
(43) Date of publication of application: **06.01.2016**
(21) Application number: 15175125.2
(22) Date of filing: 02.07.2015
(51) Int. Cl.: H01L 31/18, H01L 21/67

(54) **METHOD AND APPARATUS FOR INHIBITING LIGHT-INDUCED DEGRADATION OF PHOTOVOLTAIC DEVICE**

(30) Priority: 03.07.2014 TW 103122973; 03.07.2014 TW 103122974
(71) Applicant: Sino-American Silicon Products Inc., Hsinchu 30075 (TW)
(72) Inventor: Tjahjono, Budi, Hsinchu 30075 (TW); Yang, Ming-Jui, Hsinchu 30075 (TW); Liu, Chien-Hong, Hsinchu 30075 (TW); Shen, Kuo-Wei, Hsinchu 30075 (TW); Ting, Chuan-Wen, Hsinchu 30075 (TW); Wu, Wen-Sheng, Hsinchu 30075 (TW)
(74) Representative: Delorme, Nicolas

(57) **Abstract**

A method for inhibiting light-induced degradation of a photovoltaic device (2) includes steps of: a) subjecting the photovoltaic device (2) to an illumination treatment using a light having a wavelength not less than 300 nm to heat the photovoltaic device (2) in the absence of ambient light; and b) maintaining the temperature of the photovoltaic device (2) above an annealing temperature of the photovoltaic device (2) for at least 0.5 minute. An apparatus (1) for inhibiting light-induced degradation of a photovoltaic device (2) is also disclosed.

## Description

This disclosure relates to a method and apparatus for inhibiting light-induced degradation of a photovoltaic device.

Photovoltaic devices, such as solar cells, generally suffer from a negative effect known as light-induced degradation. Solar cells are mostly fabricated from a substrate made from crystalline silicon. During the growth of the crystalline silicon, oxygen atoms (impurities) are incorporated into molten silicon together with boron atoms used as a dopant. When a solar cell fabricated from a substrate made from crystalline silicon is illuminated, the oxygen atoms and the boron atoms form boron-oxygen defects which are electrically active impurities. The electrical properties of the solar cell may be negatively affected due to reduced lifetime of minority carriers in the substrate caused by the boron-oxygen defects. Additionally, due to the formation of the boron-oxygen defects, the material quality of the substrate will deteriorate during the first operating hours of the solar cell, and the efficiency of the solar cell will drop until it reaches saturation at a certain end value. This phenomenon is known as the light-induced degradation.

There are various approaches for reducing the light-induced degradation of the photovoltaic devices in the art.

A first approach is the magnetic Czochralski method, which is based on minimizing the oxygen impurities contained in a molten silicon material during the Czochralski method. However, since the magnetic Czochralski method is relatively complicated, a monocrystalline silicon made by the magnetic Czochralski method is more expensive than that made by the Czochralski method.

Another approach is to reduce boron concentration in the crystalline silicon. When the boron concentration is advantageously lowered to about 1 x 10¹⁶ cm⁻³, the light-induced degradation of the photovoltaic devices made by the crystalline silicon may be reduced. However, the photoelectric conversion efficiency of the photovoltaic devices may be undesirably reduced.

In addition, silicon wafers may be fabricated using a float-zone method. Silicon wafers made by the float-zone method have the highest quality, but are the most expensive and are mainly used in the electronics field.

Furthermore, there are attempts to replace boron with other dopants, for example, gallium. However, due to its solubility behaviour in silicon, gallium has the decisive disadvantage that it is very difficult to achieve a homogeneous distribution. Thus, a large number of rejects would have to be expected on an industrial scale and such attempts are currently considered infeasible industrially.

A further approach is to use phosphorus as dopant, which involves using n-type silicon as substrate material. However, n-type substrate is not common in the industry and such approach would require a modification of the production process.

US 8,263,176 discloses a method for fabricating a photovoltaic element with stabilized efficiency, in which a stabilization treatment is performed by maintaining the temperature of a silicon substrate within a temperature range of from 50°C to 230°, and generating excess minority carriers in the silicon substrate by illuminating the silicon substrate using light having a radiation intensity preferably higher than 10 W/m².

There is thus still a need in the art to further reduce the light-induced degradation of photovoltaic devices so as to further stabilize the photoelectric conversion efficiency of the photovoltaic devices.

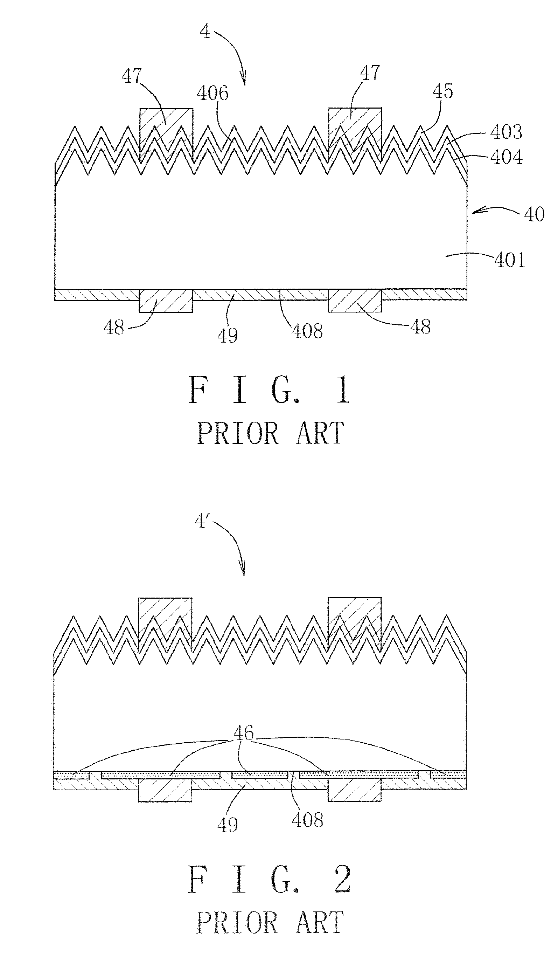

Referring to Figure 1, a typical photovoltaic device 4 is shown to include a semiconductor structure 40 which has a front surface 406 for receiving light, a back surface 408 opposite to the front surface 406, and a junction 404. The semiconductor structure 40 includes a silicon substrate 401 of a first conductive type. The silicon substrate 401 may be a monocrystalline silicon substrate, a mono-like silicon substrate, or a polycrystalline silicon substrate. The silicon substrate 401 usually has a thickness ranging from 150 µm to 220 µm. The junction 404 may be a p-n junction, an n-p junction, a p-i-n junction, an n-i-p junction, a dual junction, a multi junction, or the like.

The front surface 406 is usually subjected to a texturing treatment, which may be an etching treatment using an acid or base solution, to form a pyramid texture configuration. The light reflectivity of the front surface 406 may be effectively reduced by the pyramid texture configuration.

A semiconductor area 403 of a second conductive type is formed by superficial in-diffusion of a dopant such as boron, phosphorus, or arsenic into the front surface 406 so as to form an emitter layer of the photovoltaic device 4. In one configuration of the photovoltaic device 4, the silicon substrate 401 is of a p-type and the semiconductor area 403 is of an n-type. In an alternative configuration of the photovoltaic device 4, the silicon substrate 401 is of an n-type and the semiconductor area 403 is of a p-type.

A positive electrode 47 is formed on the front surface 406, and an ohmic contact is formed between the positive electrode 47 and the front surface 406. The positive electrode 47 may be formed by screen printing or coating a predetermined metal paste (for example, silver paste) onto the front surface 406 followed by sintering. During sintering, glass powders contained in the silver paste pass through an anti-reflective layer 45 formed on the front surface 406 to contact silicon on the front surface 406 so as to form the ohmic contact between the positive electrode 47 and the front surface 406.

At least one backside bus electrode 48 is formed on the back surface 408. The backside bus electrode 48 is usually made of silver paste. A back electrode 49 is formed on the back surface 408 and covers the entire back surface 408 except the area formed with the backside bus electrode 48. The back electrode 49 is usually made of aluminum paste. The backside bus electrode 48 and the back electrode 49 may be formed by screen printing or coating predetermined metal pastes onto the back surface 408 followed by co-firing at a temperature ranging from 570 °C to 840 °C.

Referring to Figure 2, a high efficiency photovoltaic device 4' is shown to have a configuration similar to that of the photovoltaic device 4 shown in Figure 1 except that the high efficiency photovoltaic device 4' further includes a passivating layer 46 formed on the back surface 408. The back electrode 49 contacts a relatively small area of the back surface 408 due to the presence of the passivating layer 46 on the back surface 408. When the stabilization treatment disclosed in US 8,263,176 is used to inhibit light-induced degradation of the photovoltaic device 4 and the high efficiency photovoltaic device 4', the inhibition effect for the high efficiency photovoltaic device 4' is undesirably much lower than that for the photovoltaic device 4 because the back electrode 4 9 contacts a relatively small area of the back surface 408 of the high efficiency photovoltaic device 4'.

A first object of this disclosure is to provide a method for inhibiting light-induced degradation of a photovoltaic device, which is useful for more effectively inhibiting light-induced degradation of a typical photovoltaic device and a high efficiency photovoltaic device as well.

A second object of this disclosure is to provide an apparatus for inhibiting light-induced degradation of a photovoltaic device.

According to a first aspect of this disclosure, there is provided a method for inhibiting light-induced degradation of a photovoltaic device, which includes the steps of: a) subjecting the photovoltaic device to an illumination treatment using a light having a wavelength not less than 300 nm to heat the photovoltaic device in the absence of ambient light; and b) maintaining the temperature of the photovoltaic device above an annealing temperature of the photovoltaic device for at least 0.5 minute.

According to a second aspect of this disclosure, there is provided an apparatus for inhibiting light-induced degradation of a photovoltaic device. The apparatus includes a housing, a light source, a conveyer having a conveying segment, a temperature sensor, a thermal-conditioning device, and a controller. The housing has a ceiling wall extending along a longitudinal direction, a base wall spaced apart from the ceiling wall, and a surrounding wall disposed between the ceiling wall and the base wall to define a chamber. The surrounding wall has an entry port and an exit port opposite to the entry port in the longitudinal direction. The light source is mounted on the ceiling wall and is configured to emit a beam of illuminating light downward. The conveying segment of the conveyer is for conveying the photovoltaic device and is configured to extend along a running route which runs from the entry port to the exit port, and which is parallel and proximate to the base wall so as to permit the photovoltaic device to be illuminated by the beam of illuminating light. The temperature sensor is mounted in the chamber to detect the temperature of the photovoltaic device. The thermal-conditioning device is used for conditioning the temperature of the photovoltaic device. The controller is configured to control the light emitted by the light source and the thermal-conditioning device based on the temperature detected by the temperature sensor.

Other features and advantages of this disclosure will become apparent in the following detailed description of the embodiments with reference to the accompanying drawings, of which:
Figure 1 is a schematic sectional view of a typical photovoltaic device;
Figure 2 is a schematic sectional view of a high efficiency photovoltaic device;
Figure 3 is a schematic view illustrating an embodiment of a method for inhibiting light-induced degradation of a photovoltaic device according to this disclosure;
Figure 4 is a schematic view illustrating a first embodiment of an apparatus for inhibiting light-induced degradation of a photovoltaic device according to this disclosure;
Figure 5 is a schematic view illustrating a second embodiment of an apparatus for inhibiting light-induced degradation of a photovoltaic device according to this disclosure;
Figure 6 is a schematic view illustrating a third embodiment of an apparatus for inhibiting light-induced degradation of a photovoltaic device according to this disclosure;
Figure 7 is a schematic view illustrating a fourth embodiment of an apparatus for inhibiting light-induced degradation of a photovoltaic device according to this disclosure; and
Figure 8 is a schematic view illustrating a fourth embodiment of an apparatus for inhibiting light-induced degradation of a photovoltaic device according to this disclosure.

Before the present invention is described in greater detail, it should be noted that like elements are denoted by the same reference numerals throughout the disclosure.

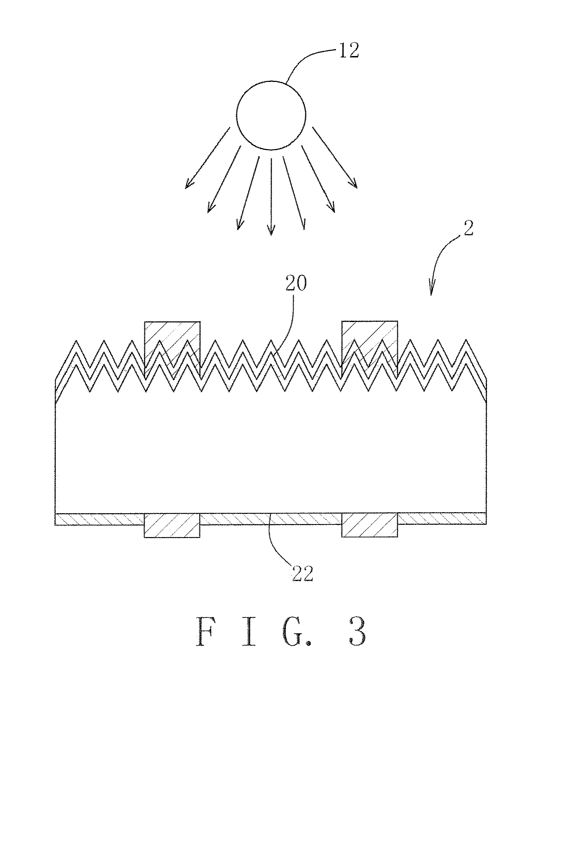

With reference to Figure 3, an embodiment of a method for inhibiting light-induced degradation of a photovoltaic device according to this disclosure includes the following steps.

### A)Illumination treatment:

A photovoltaic device 2 is subjected to an illumination treatment using light emitted from a light source 12 and having a wavelength not less than 300 nm to heat the photovoltaic device 2 in the absence of ambient light.

The light source 12 for the illumination treatment is an infrared lamp, a halogen lamp, a semiconductor light-emitting device, an organic light-emitting device, or combinations thereof.

Examples of the photovoltaic device 2 include a boron-doped, oxygen containing silicon substrate, a boron-gallium-doped, oxygen containing silicon substrate, and the like. The photovoltaic device 2 has a top surface 20 and a back surface 22 opposite to the top surface 20.

The light emitted from the light source 12 includes a short wavelength light having a wavelength from 300 nm to 450 nm, and a long wavelength light having a wavelength not less than 450 nm, and preferably from 450 nm to 1000 nm. The short wavelength light may pass through the top surface 20 of the photovoltaic device 2, but cannot reach the back surface 22 of the photovoltaic device 2. The long wavelength light may pass through the top surface 20 of the photovoltaic device 2 and reach the back surface 22 of the photovoltaic device 2. Therefore, the light used for the illumination treatment preferably has a wavelength from 450 nm to 1000 nm (i.e., the long wavelength light).

The temperature of the photovoltaic device 2 subjected to the illumination treatment is advantageously raised to be higher than an annealing temperature of the photovoltaic device 2 . Specifically, when the photovoltaic device 2 to be illuminated is a boron-doped, oxygen containing silicon substrate, the annealing temperature is 230°C.

### B) Maintaining the temperature of the photovoltaic device:

The temperature of the photovoltaic device 2 is maintained above the annealing temperature of the photovoltaic device 2 and preferably below 600°C for at least 0.5 minute. When the photovoltaic device 2 to be illuminated is a boron-doped, oxygen containing silicon substrate, the temperature of the photovoltaic device 2 is maintained above 230°C, preferably below 600°C, and more preferably from 230°C to 577°C. When the temperature of the photovoltaic device 2 is higher than 577°C, the photovoltaic device 2 will be severely damaged.

### C) Detecting:

The temperature of the photovoltaic device 2 is detected using a sensor when step b) is performed. When the temperature of the photovoltaic device 2 detected by the sensor falls outside the range of from 230 °C to 577 °C, the step of maintaining (i.e., step b)) is aided by thermal-conditioning. Specifically, when the temperature of the photovoltaic device 2 detected by the sensor is lower than 230°C, thermal-conditioning is implemented by thermal-heating. When the temperature of the photovoltaic device 2 detected by the sensor is higher than 577°C, the thermal-conditioning is implemented by cooling.

In order to maintain the temperature of the photovoltaic device 2 within the range from 230°C to 577°C, a light-illuminated surface (i.e., the top surface 20) of the photovoltaic device 2 should have a light intensity of at least 0.5 Sun, and preferably from 0.9 Sun to 5 Sun.

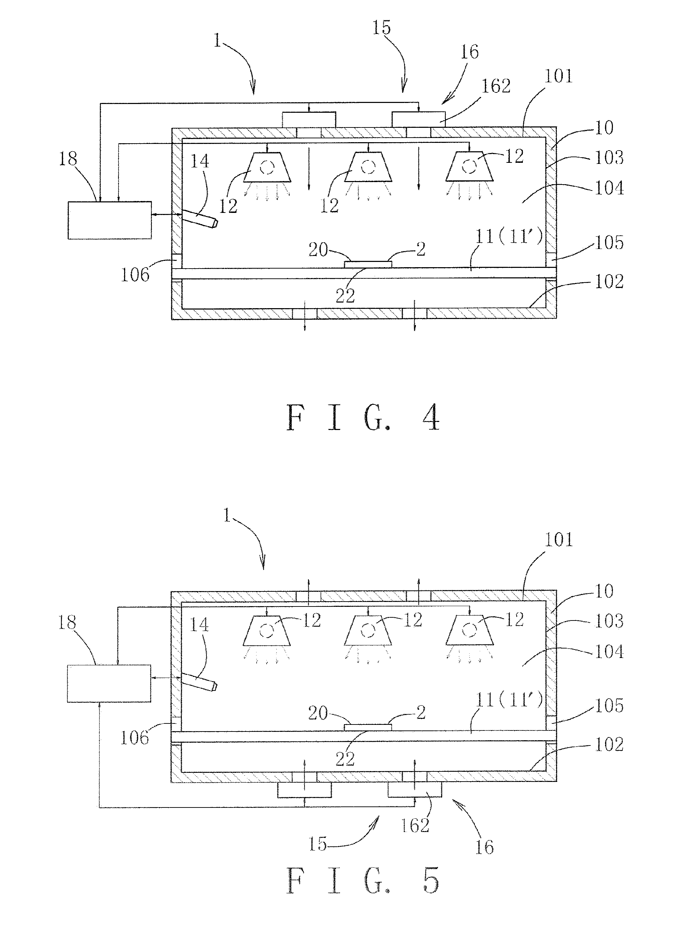

Referring to Figure 4, a first embodiment of an apparatus 1 for inhibiting light-induced degradation of a photovoltaic device 2 of this disclosure is shown to include a housing 10, at least one light source 12 (a plurality of light sources 12 are illustrated in Figure 4), a conveyer 11 having a conveying segment 11', a temperature sensor 14, a thermal-conditioning device 15, and a controller 18.

The housing 10 has a ceiling wall 101 extending along a longitudinal direction, a base wall 102 spaced apart from the ceiling wall 101, and a surrounding wall 103 disposed between the ceiling wall 101 and the base wall 102 to define a chamber 104. The surrounding wall 103 has an entry port 105 and an exit port 106 opposite to the entry port 105 in the longitudinal direction.

The at least one light source 12 is mounted on the ceiling wall 101 and is configured to emit a beam of illuminating light downward. The at least one light source includes an infrared lamp, a halogen lamp, a semiconductor light-emitting device, an organic light-emitting device, or combinations thereof.

When the at least one light source 12 is used in the method for inhibiting light-induced degradation of a photovoltaic device of this disclosure, as described above, the at least one light source 2 emits light which includes a short wavelength light having a wavelength from 300 nm to 450 nm, and a long wavelength light having a wavelength not less than 450 nm, and preferably from 450 nm to 1000 nm. The short wavelength light may pass through a top surface 20 of the photovoltaic device 2, but cannot reach a back surface 22 of the photovoltaic device 2. The long wavelength light may pass through the top surface 20 of the photovoltaic device 2 and reach the back surface 22 of the photovoltaic device 2. Therefore, the light emitted from the light sources 12 preferably has a wavelength from 450 nm to 1000 nm (i.e., the long wavelength light). Furthermore, the light emitted by the at least one light source 12 is such that the light-illuminated surface (i.e., the top surface 20) of the photovoltaic device 2 have a light intensity of at least 0.5 Sun, and preferably from 0.9 Sun to 5 Sun.

It should be noted that the apparatus 1 for inhibiting light-induced degradation of a photovoltaic device 2 of this disclosure may be used to perform other illumination treatments, such as that disclosed in US 8, 263, 176, and that the at least one light source 2 may be modified to provide illuminating light that meets specific requirements for other illumination treatments.

The conveying segment 11' of the conveyer 11 is for carrying the photovoltaic device 2 and is configured to extend along a running route which runs from the entry port 105 to the exit port 106, and which is parallel and proximate to the base wall 102 so as to permit the photovoltaic device 2 to be illuminated by the beam of illuminating light.

The temperature sensor 14 is mounted in the chamber 104 to detect the temperature of the photovoltaic device 2. Examples of the temperature sensor 14 suitable for this disclosure include an infrared temperature sensor, a thermocoupling temperature sensor, and the like.

The thermal-conditioning device 15 is used for conditioning the temperature of the photovoltaic device 2. In this embodiment, the thermal-conditioning device 15 includes a cooling device 16 for cooling the temperature of the photovoltaic device 2 when the temperature of the photovoltaic device 2 detected by the temperature sensor 14 is higher than an upper limit of a desirable range (for example, from 230°C to 577°C as mentioned above) of temperature for the photovoltaic device 2 in the aforesaid maintaining step B).

The cooling device 16 is mounted on the ceiling wall 101 and includes a gas cooling unit 162. The gas cooling unit 162 provides a cooling gas such as cooling air, cooling inert gas, or the like for cooling the photovoltaic device 2. In this embodiment, the cooling gas provided by the gas cooling unit 162 flows from the ceiling wall 101 to the base wall 102.

The controller 18 is configured to control the light emitted by the light source 12 and the thermal-conditioning device 15 based on the temperature detected by the temperature sensor 14.

Referring to Figure 5, a second embodiment of the apparatus 1 for inhibiting light-induced degradation of a photovoltaic device 2 of this disclosure is illustrated to have a configuration similar to that of the first embodiment except that the cooling device 16 is mounted on the base wall 102 and that the cooling gas provided by the gas cooling unit 162 flows from the base wall 102 to the ceiling wall 101.

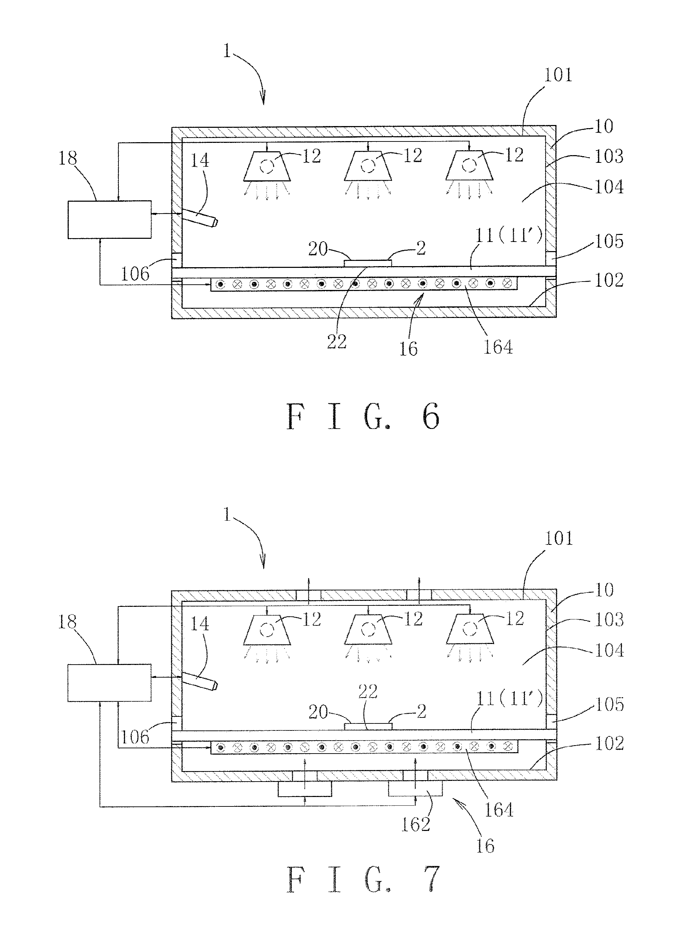

Referring to Figure 6, a third embodiment of the apparatus 1 for inhibiting light-induced degradation of a photovoltaic device 2 of this disclosure is illustrated to have a configuration similar to that of the first embodiment except that the cooling device 16 includes a liquid cooling unit 164 which is mounted below the conveying segment 11'. The liquid cooling unit 164 is provided with a cooling liquid such as water or refrigerant for cooling the photovoltaic device 2.

Referring to Figure 7, a fourth embodiment of the apparatus 1 for inhibiting light-induced degradation of a photovoltaic device 2 of this disclosure is illustrated to have a configuration similar to that of the second embodiment except that the cooling device 16 further includes the liquid cooling unit 164, which is mounted below the conveying segment 11'.

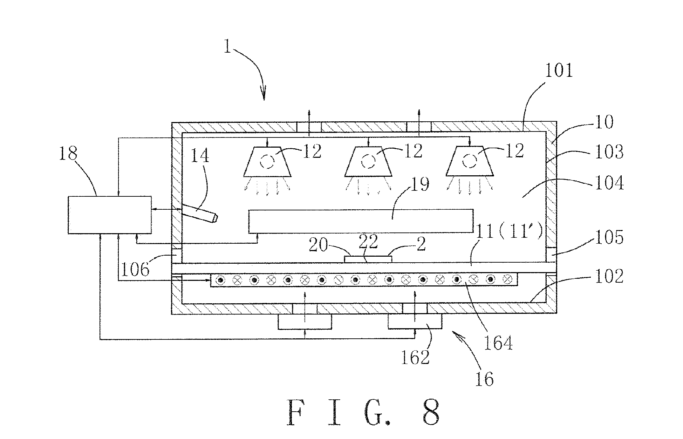

Referring to Figure 8, a fifth embodiment of the apparatus 1 for inhibiting light-induced degradation of a photovoltaic device 2 of this disclosure is illustrated to have a configuration similar to that of the fourth embodiment except that thermal-conditioning device 15 further includes a thermal-heating device 19 mounted in the chamber 104 for thermally heating the photovoltaic device 2.

To demonstrate the advantageous effect of the method of this disclosure, experiments were conducted. A batch of tens of photovoltaic devices were treated by the method of this disclosure, in which the temperature of the photovoltaic devices was maintained at 250°C for 10 min. The initial photoelectric conversion efficiencies of the photovoltaic devices after the treatment were measured, and an average initial photoelectric conversion efficiency was calculated and is shown in Table 1. The light-induced degradation of the photovoltaic devices after the treatment was tested under a condition simulating sunlight illumination. The photoelectric conversion efficiencies of the photovoltaic devices after the light-induced degradation test were measured, and an average photoelectric conversion efficiency after degradation test was calculated and is shown in Table 1. A degradation ratio was calculated by dividing the difference between the average initial photoelectric conversion efficiency and the average photoelectric conversion efficiency after degradation test by the average initial photoelectric conversion efficiency. The degradation ratio is also shown in Table 1.

The initial photoelectric conversion efficiencies of another batch of tens of photovoltaic devices without treatment by the method of this disclosure were measured, and an average thereof was calculatd and is shown in Table 1. The light-induced degradation of the photovoltaic devices was tested under a condition simulating sunlight illumination. The photoelectric conversion efficiencies of the photovoltaic devices after the light-induced degradation test were measured, and an average thereof was calculated and is shown in Table 1. A degradation ratio was calculated in the same manner and is shown in Table 1.

**Table 1**

| | Average initial photoelectric conversion efficiency | Average photoelectric conversion efficiency after degradation test | Average degradation ratio |
|---|---|---|---|
| Photovoltaic device treated by the method of this disclosure | 20.083% | 19.897% | 0.925% |
| Photovoltaic device without treatment by the method of this disclosure | 20.03% | 19.02% | 5.03% |

Batches of tens of photovoltaic devices were treated by the method of this disclosure, in which the temperature of the photovoltaic devices was maintained at 250°C for different time periods (i.e., 5 min, 10 min, and 12 min). An average reduction ratio of the photoelectric conversion efficiencies of each of the batches of the photovoltaic devices after the treatment was calculated by dividing the difference between the photoelectric conversion efficiencies before and after the treatment using the method of this disclosure by the photoelectric conversion efficiency before the treatment using the method of this disclosure. The results are shown in Table 2.

For purpose of comparison, a batch of tens of photovoltaic devices were treated by the illumination stabilization treatment disclosed in US 8,263,176, in which the temperature of the photovoltaic devices was maintained at 200°C for different time periods (i.e., 10 min and 15 min). The average reduction ratio of the photoelectric conversion efficiencies of each of the batches of the photovoltaic devices after the illumination stabilization treatment disclosed in US 8,263,176 was calculated. The results are also shown in Table 2.

**Table 2**

| | Treatment Time (min) | Average reduction ratios of photoelectric conversion efficiencies |
|---|---|---|
| Photovoltaic device treated by the method of this disclosure | 5 | 0.21% |
| | 10 | 0.08% |
| | 12 | 0.15% |
| Photovoltaic device treated by the illumination stabilization treatment disclosed in US 8,263,176 | 10 | 0.56% |
| | 15 | 0.34% |

As shown in Table 2, the reduction ratio of the photoelectric conversion efficiency of a photovoltaic device treated by the method of this disclosure is substantially lower than the reduction ratio of the photoelectric conversion efficiency of a a photovoltaic device treated by the illumination stabilization treatment disclosed in US 8,263,176.

## Claims

1. A method for inhibiting light-induced degradation of a photovoltaic device (2), **characterized by** steps of:
a) subjecting the photovoltaic device (2) to an illumination treatment using a light having a wavelength not less than 300 nm to heat the photovoltaic device (2) in the absence of ambient light; and
b) maintaining the temperature of the photovoltaic device (2) above an annealing temperature of the photovoltaic device (2) for at least 0.5 minute.

2. The method according to Claim 1, **characterized in that** the temperature of the photovoltaic device (2) is maintained below 600°C.

3. The method according to Claim 2, **characterized in that** the step of maintaining is aided by a thermal-conditioning.

4. The method according to Claim 3, **characterized in that** the thermal-conditioning is implemented by thermal-heating, cooling, or a combination thereof.

5. The method according to Claim 1, further **characterized by** using a sensor (14) to detect the temperature of the photovoltaic device (2) when the step b) is performed.

6. The method according to one of Claims 1 to 5, **characterized in that** the photovoltaic device (2) is aboron-doped, oxygen containing silicon substrate, and the annealing temperature is 230°C.

7. The method according to Claim 6, **characterized in that** the temperature of the photovoltaic device (2) is maintained within a range from 230°C to 577°C.

8. The method according to Claim 6, **characterized in that** the light for the illumination treatment has a wavelength ranging from 450 nm to 1000 nm.

9. The method according to one of Claims 1 to 8, **characterized in that** the photovoltaic device (2) includes a light-illuminated surf ace (20) having a light intensity of at least 0.5 Sun.

10. The method according to Claim 9, **characterized in that** the light intensity ranges from 0.9 Sun to 5 Sun.

11. The method according to Claim 1, **characterized in that** the light for the illumination treatment is emitted from an infrared lamp, a halogen lamp, a semiconductor light-emitting device, an organic light-emitting device, or combinations thereof.

12. The method according to one of Claims 1 to 11, **characterized in that** the photovoltaic device (2) is a boron-doped, oxygen containing silicon substrate or a boron-gallium-doped, oxygen containing silicon substrate.

13. An apparatus (1) for inhibiting light-induced degradation of a photovoltaic device (2), **characterized by**:
a housing (10) having a ceiling wall (101) extending along a longitudinal direction, a base wall (102) spaced apart from said ceiling wall (101), and a surrounding wall (103) disposed between said ceiling wall (101) and said base wall (102) to define a chamber (104), said surrounding wall (103) having an entry port (105) and an exit port (106) opposite to said entry port (105) in the longitudinal direction;
a light source (12) mounted on said ceiling wall (101) and configured to emit a beam of illuminating light downward;
a conveyer (11) having a conveying segment (11') for carrying the photovoltaic device (2), said conveying segment (11') being configured to extend along a running route which runs from said entry port (105) to said exit port (106), and which is parallel and proximate to said base wall (102) so as to permit the photovoltaic device (2) to be illuminated by said beam of illuminating light;
a temperature sensor (14) mounted in said chamber (104) to detect the temperature of the photovoltaic device (2);
a thermal-conditioning device (15) for conditioning the temperature of the photovoltaic device (2); and
a controller (18) configured to control the light emitted by said light source (12) and said thermal-conditioning device (15) based on the temperature detected by the temperature sensor (14).

14. The apparatus (1) according to Claim 13, **characterized in that** said light source (12) includes an infrared lamp, a halogen lamp, a semiconductor light-emitting device, an organic light-emitting device, or combinations thereof.

15. The apparatus (1) according to Claim 13, **characterized in that** said thermal-conditioning device (15) includes a cooling device (16).

16. The apparatus (1) according to Claim 13, **characterized in that** said thermal-conditioning device (15) includes a thermal heating device (19).

17. The apparatus (1) according to Claim 15, **characterized in that** said thermal-conditioning device (15) further includes a thermal heating device (19).
